# EUROPEAN PATENT SPECIFICATION

(11) **EP 3 038 090 B1**
(45) Date of publication and mention of the grant of the patent: **11.05.2022**
(21) Application number: 15200320.8
(22) Date of filing: 16.12.2015
(51) Int. Cl.: G09G 3/3258, G09G 3/20, G09G 3/3233

(54) **ORGANIC LIGHT EMITTING DISPLAY AND METHOD OF DRIVING THE SAME**
ORGANISCHE LICHTEMITTIERENDE ANZEIGE UND VERFAHREN ZU DEREN ANTRIEB
AFFICHAGE ELECTROLUMINESCENT ORGANIQUE ET SON PROCEDE DE COMMANDE

(30) Priority: 24.12.2014 KR 20140188863
(43) Date of publication of application: 29.06.2016
(73) Proprietor: LG Display Co., Ltd., Yeongdeungpo-gu Seoul 150-721 (KR)
(72) Inventor: PARK, Dongwon, 410-360 Gyeonggi-do (KR); KWON, Yongchul, 136-073 Seoul (KR)
(74) Representative: Morrall, Jonathan Ian McLachlan

(56) References cited:
- EP-A2- 1 528 533
- US-A1- 2006 273 999
- US-A1- 2007 080 906
- US-A1- 2010 188 393

## Description

This application claims the benefit of Korean Patent Application No. 10-2014-0188863, filed on December 24, 2014.

### BACKGROUND

### Field

The present invention relates to an Organic Light Emitting Display (OLED) and a method of driving the same.

### Related Art

An organic light emitting element used for an OLED is a self-luminance element in which a light emitting layer is formed between two electrodes. By injecting electrons and holes from an electron cathode and a hole anode, respectively, into a light emitting layer, the organic light emitting element is an element that emits light when excitons in which the injected electrons and holes are coupled drop from an excited state to a ground state.

When a scan signal, a data signal, and power are supplied to a display panel including a plurality of subpixels disposed in a matrix form, the OLED enables selected subpixels to emit light, thereby displaying an image.

A driving method of the OLED includes an analog driving method of driving a display panel by supplying a current or a voltage to the display panel and a digital driving method of adjusting an emission time. The digital driving method includes an Address Display Separation (ADS) driving method and an Address While Display (AWD) driving method.

The AWD driving method is implemented so that lengths of subframes have different weighted times or emission times. In the AWD driving method, a subpixel is turned on and turned off in every subframe and in this case, luminance is determined in proportional to accumulation of a turn-on time of the subpixel.

In a conventionally suggested AWD driving method, an erase time (Erase) that erases a data signal is inserted into only subordinate subframes having a time smaller than 1 horizontal addressing time (1V addressing). Therefore, in a conventionally suggested AWD driving method, an error occurs that changes a voltage that determines actual luminance of a subpixel for a present subframe according to a state (turn on or turn off) of a subpixel for a previous subframe. As a result, in the conventionally suggested AWD driving method, an image quality deviation occurs due to an error occurrence factor and thus enhancement thereof is requested.

US2007/0080906 A1 discloses a display apparatus with an active matrix display panel which can suppress gate stress to prevent a degradation of the display quality. Specified at least one pixel section having a light emitting element to driven for light emission in one row is supplied with a data pulse indicative of a first gate voltage of a thin film transistor upon supply of a display scanning pulse. Subsequently, each pixel in the one row is supplied with a reset scanning pulse, and when supplying a reset scanning pulse, the at least one pixel section is supplied with a reset pulse indicative of a second gate voltage of the thin film transistor for making the polarity of agate-to-source voltage or gate-to-drain voltage of the thin film transistor reverse to that during light emission driving.

### SUMMARY

The present invention is set forth in the independent claims.

### BRIEF DESCRIPTION OF THE DRAWINGS

The accompany drawings, which are included to provide a further understanding of the invention and are incorporated on and constitute a part of this specification illustrate embodiments of the invention and together with the description serve to explain the principles of the invention.
FIG.1 is a block diagram illustrating a configuration of an OLED according to a first exemplary embodiment of the present invention;
FIG.2 is a diagram illustrating a conventional AWD driving method;
FIG.3 is a diagram illustrating an AWD driving method according to an exemplary embodiment of the present invention;
FIG.4 is a diagram illustrating a circuit configuration of a subpixel according to an exemplary embodiment of the present invention;
FIG. 5 is a diagram illustrating a driving waveform of the subpixel of FIG. 4;
FIG.6 is a diagram illustrating a circuit configuration of a subpixel according to a first exemplary embodiment , which is not covered by the present invention;
FIG. 7 is a diagram illustrating a driving waveform of the subpixel of FIG. 6;
FIG.8 is a diagram illustrating a circuit configuration of a subpixel according to a second exemplary embodiment , which is not covered by the present invention;
FIG. 9 is a diagram illustrating a driving waveform of the subpixel of FIG. 8;
FIG. 10 is a diagram illustrating a circuit configuration of a subpixel according to a fourth exemplary embodiment , which is not covered by the present invention; and
FIG. 11 is a diagram illustrating a driving waveform of the subpixel of FIG. 10.

### DETAILED DESCRIPTION

Reference will now be made in detail embodiments of which are illustrated in the accompanying drawings.

Hereinafter, exemplary embodiments will be described in detail with reference to the accompanying drawings.

### <exemplary embodiment of the invention>

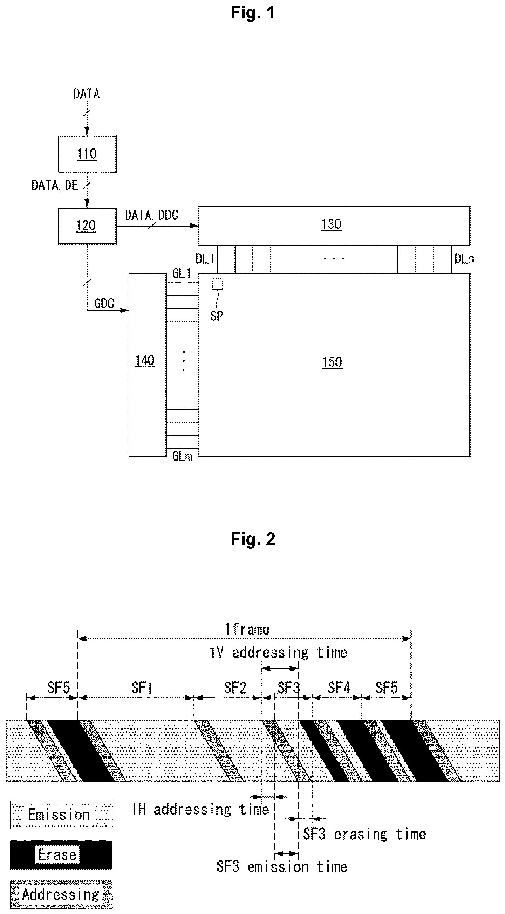

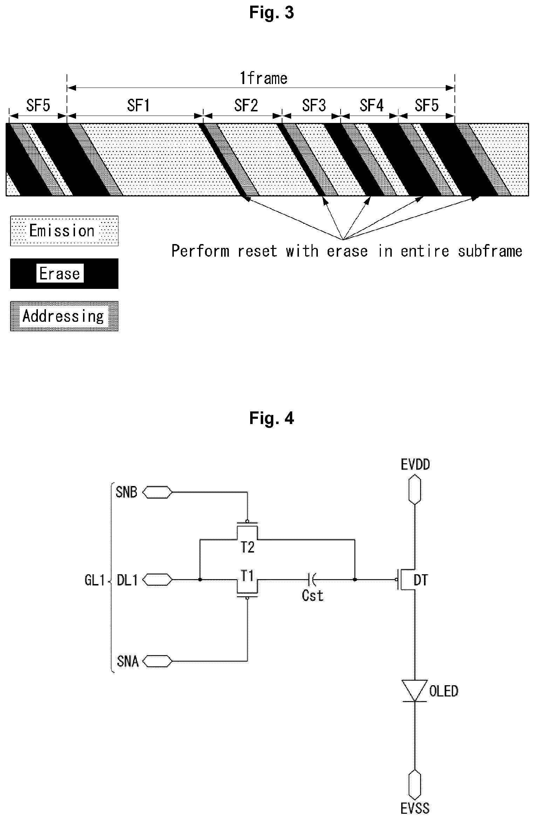

FIG. 1 is a block diagram illustrating a configuration of an Organic Light Emitting Display (OLED) according to a exemplary embodiment of the present invention, FIG. 2 is a diagram illustrating a conventional AWD driving method, and FIG. 3 is a diagram illustrating an AWD driving method according to an exemplary embodiment of the present invention.

As shown in FIG. 1, an OLED according to the exemplary embodiment of the present invention includes an image processor 110, a timing controller 120, a data driver 130, a scan driver 140, and a display panel 150.

The image processor 110 outputs a data enable signal DE together with a data signal DATA supplied from the outside. The image processor 110 may output at least one of a vertical synchronization signal, a horizontal synchronization signal, and a clock signal in addition to the data enable signal DE, but for convenience of description, the signals will be omitted.

The timing controller 120 receives the supply of a data signal DATA together with a driving signal including a data enable signal DE or a vertical synchronization signal, a horizontal synchronization signal, and a clock signal from the image processor 110. The timing controller 120 outputs a gate timing control signal GDC for controlling operation timing of the scan driver 140 and a data timing control signal DDC for controlling operation timing of the data driver 130 based on a driving signal.

The data driver 130 samples and latches a data signal DATA supplied from the timing controller 120 in response to a data timing control signal DDC supplied from the timing controller 120 and converts and outputs the data signal DATA to a gamma reference voltage. The data driver 130 outputs a data signal DATA arranged in a subframe (or subfield) unit through data lines DL1-DLn. The data driver 130 is formed in an Integrated Circuit (IC) form.

The scan driver 140 outputs a scan signal while shifting a level of a gate voltage in response to a gate timing control signal GDC supplied from the timing controller 120. The scan driver 140 outputs a scan signal through scan lines GL1-GLm. The scan driver 140 is formed in an Integrated Circuit (IC) form or is formed in a Gate In Panel method in the display panel 150.

The display panel 150 displays an image to correspond to a data signal DATA and a scan signal supplied from the data driver 130 and the scan driver 140. The display panel 150 includes subpixels SP that display an image.

The subpixel is formed with a Top-Emission method, a Bottom-Emission method, or a Dual-Emission method according to a structure. The subpixels SP include a red subpixel, a green subpixel, and a blue subpixel or include a white subpixel, a red subpixel, a green subpixel, and a blue subpixel. The subpixels SP may have at least one different light emitting area according to a light emitting characteristic.

As shown in FIG. 2, in a conventional Address While Display (AWD) driving method, a data signal of 1 frame (or 1 vertical addressing time (1V addressing time)) is formed with subframes SF1-SF5. The subframes SF1-SF5 are formed to have different weighted times (or emission times).

Superordinate subframes SF1-SF3 are each formed with an addressing time (Addressing) and an emission time (Emission), and subordinate subframes SF4 and SF5 are each formed with an addressing time (Addressing), an emission time (Emission), and an erase time (Erase).

As described above, an AWD driving method is a digital driving method of adjusting Emission of an organic light emitting diode. The digital driving method divides 1frame into a plurality of subframe SF1-SF4 and determines a gray scale with a rate of Emission.

In the AWD driving method, only when addressing of one subframe is terminated, addressing of a next subframe is performed. Therefore, when Addressing of one subframe is longer than Emission of a corresponding subframe, in order to have a time until addressing of a next subframe is started, a time that erases a data signal is required.

Each subframe represents one bit, and Emission of each subframe increases or reduces by approximately two times. A first subframe SF1 is a subframe in which Emission is largest among five subframes, and a fifth subframe SF5 is a subframe in which Emission is smallest among five subframes. In the drawing, Emission has size order of SF1 > SF2 >SF3 > SF4 > SF5.

In the AWD driving method, a subpixel is turned on and turned off in every subframe and in this case, luminance is determined in proportional to accumulation of a turn-on time of the subpixel. However, in a conventionally suggested AWD driving method, Erase that erases a data signal is inserted into only subordinate subframes SF4 and SF5 having a time smaller than 1V addressing.

Therefore, in a conventionally suggested AWD driving method, an error occurs that changes a voltage that determines actual luminance of a subpixel for a present subframe according to a state (turn on or turn off) of a subpixel for a previous subframe. As a result, in the conventionally suggested AWD driving method, an image quality deviation occurs due to an error occurrence factor and thus enhancement thereof is requested.

As shown in FIG. 3, in an AWD driving method according to the exemplary embodiment of the present invention, a data signal of 1frame is formed with subframes SF1-SF5. The subframes SF1-SF5 are formed to have different weighted times (or emission times).

In the AWD driving method according to a first exemplary embodiment of the present invention, in order to prevent an image quality deviation from occurring due to error occurrence caused in the conventionally suggested AWD driving method, entire subframes SF1-SF5 are each formed with Addressing, Emission, and Erase.

In this way, in order to solve an error in which a voltage that determines actual luminance of a subpixel for a present subframe changes according to a state (turn on or turn off) of a subpixel for a previous subframe, an AWD driving method according to a first exemplary embodiment of the present invention inserts Erase (or reset) into every subframe. Erase is defined as operation that short-circuits a first node and a second node that can control Emission.

In the exemplary embodiment of the present invention, in order to drive a subpixel with Erase in every subframe, a circuit configuration of the subpixel is designed as follows.

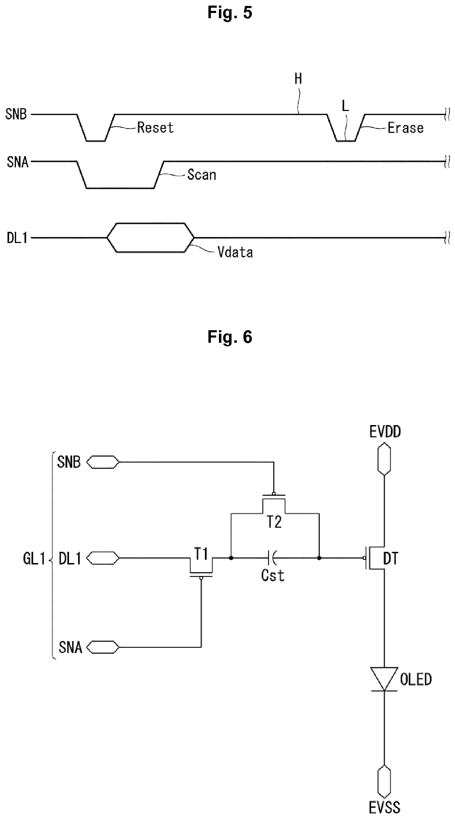

FIG. 4 is a diagram illustrating a circuit configuration of a subpixel according to the exemplary embodiment of the present invention, and FIG. 5 is a diagram illustrating a driving waveform of the subpixel of FIG. 4.

As shown in FIG. 4, a subpixel according to the exemplary embodiment of the present invention includes a first transistor T1, a second transistor T2, a capacitor Cst, a driving transistor DT, and an organic light emitting diode (OLED).

In the first transistor T1, a gate electrode is connected to an Ath scan line SNA, a first electrode is connected to a first data line DL1, and a second electrode is connected to one end of the capacitor Cst. The first transistor T1 operates to correspond to an Ath scan signal supplied through the Ath scan line SNA. When the first transistor T1 is turned on, a data signal supplied through the first data line DL1 is stored at the capacitor Cst in a data voltage form.

In the second transistor T2, a gate electrode is connected to a Bth scan line SNB, a first electrode is connected to the first data line DL1, and a second electrode is connected to the other end of the capacitor Cst. The second transistor T2 operates to correspond to a Bth scan signal supplied through the Bth scan line SNB. When the second transistor T2 is turned on, a data voltage stored at the capacitor Cst is erased.

In the capacitor Cst, one end thereof is connected to a second electrode of the first transistor T1 and the other end thereof is connected to a gate electrode of the driving transistor DT and a second electrode of the second transistor T2. The capacitor Cst provides a stored data voltage to a gate electrode of the driving transistor DT.

In the driving transistor DT, a gate electrode is connected to the capacitor Cst, a first electrode is connected to a first power source line EVDD, and a second electrode is connected to an anode electrode of the OLED. The driving transistor DT operates to correspond to a data voltage stored at the capacitor Cst.

In the OLED, an anode electrode is connected to a second electrode of the driving transistor DT and a cathode electrode is connected to a second power source line EVSS. The OLED emits light to correspond to a time in which the driving transistor DT is turned on.

In the foregoing description, a first electrode and a second electrode may be defined to a source electrode and a drain electrode or a drain electrode and a source electrode of a transistor according to a characteristic or a direction of the transistor.

A subpixel according to the exemplary embodiment of the present invention operates to correspond to a scan signal supplied through two scan lines of an Ath scan line SNA and a Bth scan line SNB. The Ath scan line SNA and the Bth scan line SNB are included in a first scan line GL1. The first transistor T1 and the second transistor T2 included in a subpixel according to the exemplary embodiment of the present invention are formed in a P type and a driving waveform thereof is shown in FIG. 5.

An Ath scan signal Scan is supplied to the Ath scan line SNA. The Ath scan signal Scan (logic low; L portion) supplied through the Ath scan line SNA defines Addressing that transfers a data signal to the subpixel. When the Ath scan signal Scan corresponding to logic low L is supplied through the Ath scan line SNA, the subpixel stores a data signal Vdata as a data voltage to correspond to Addressing.

A (B-1)th scan signal Reset and a (B-2)th scan signal Erase are supplied to the Bth scan line SNB. The (B-1)th scan signal Reset (logic low; L portion) supplied through the Bth scan line SNB defines an initialization time that initializes a subpixel. When the (B-1)th scan signal Reset corresponding to logic low L is supplied through the Bth scan line SNB, the subpixel initializes a node between the first transistor T1 and the capacitor Cst to correspond to an initialization time.

An initialization time using the (B-1)th scan signal Reset may occur before a data signal Vdata is supplied. A time point in which the (B-1)th scan signal Reset occurs may be synchronized with a time point in which the Ath scan signal Scan drops to logic low L or may be a time point a little faster than or a time point a little slower than a time point in which the Ath scan signal Scan drops to logic low L.

A (B-2)th scan signal Erase (logic low; L portion) supplied through the Bth scan line SNB defines Erase that erases a data voltage stored at a subpixel. When the (B-2)th scan signal Erase corresponding to logic low L is supplied through the Bth scan line SNB, the subpixel erases a data voltage to correspond to Erase. A time point in which the (B-2)th scan signal Erase occurs corresponds to a time point in which Emission of each subpixel is terminated.

The (B-1)th scan signal Reset and the (B-2)th scan signal Erase erase a potential of the capacitors Cst with a method of short-circuiting a node between the first transistor T1 and the capacitor Cst by turning on the second transistor T2, but are functionally different, as described above and thus the (B-1)th scan signal Reset and the (B-2)th scan signal Erase are distinguished.

A data voltage transferred through a data line is supplied as a voltage that can emit a subpixel to correspond to Addressing, but may be changed to a voltage that cannot emit (turn off) a subpixel to correspond to an initialization time or Erase.

As can be seen through FIGS. 4 and 5, in the exemplary embodiment of the present invention, driving of the second transistor T2 using a (B-1)th scan signal Reset and (B-2)th scan signal Erase supplied through a Bth scan line SNB, initialization driving of a subpixel based on the second transistor T2, and erasing driving thereof has been described as an example.

An initialization time is a time inserted to prevent in advance a change problem (problem by a parasitic component) of a node due to a long term that returns to Addressing after Erase. Therefore, a subpixel may be erasing driven using only a (B-2)th scan signal Erase supplied through the Bth scan line SNB. Further, a driving waveform of FIG. 5 is an illustration and a driving waveform may be formed in different forms according to an object and an effect.

<First exemplary embodiment not covered by the present invention>

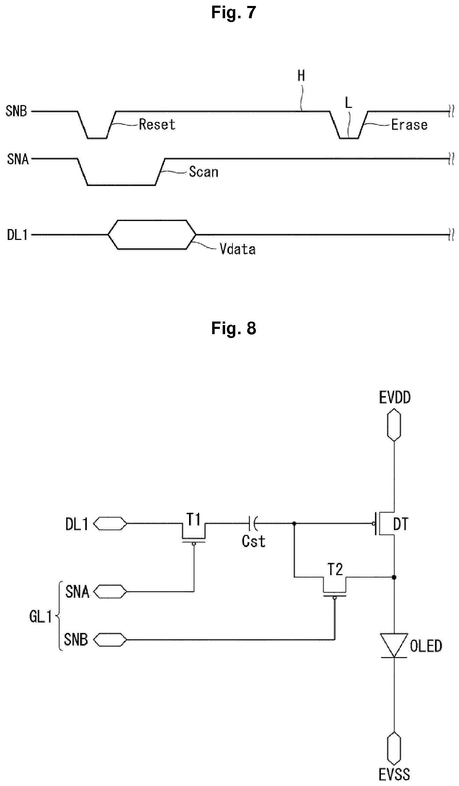

FIG. 6 is a diagram illustrating a circuit configuration of a subpixel according to a first exemplary embodiment not covered by the present invention, and FIG. 7 is a diagram illustrating a driving waveform of the subpixel of FIG. 6.

As shown in FIG. 6, a subpixel according to a first exemplary embodiment not covered by the present invention includes a first transistor T1, a second transistor T2, a capacitor Cst, a driving transistor DT, and an OLED.

In the first transistor T1, a gate electrode is connected to an Ath scan line SNA, a first electrode is connected to a first data line DL1, and a second electrode is connected to one end of the capacitor Cst. The first transistor T1 operates to correspond to an Ath scan signal supplied through the Ath scan line SNA. When the first transistor T1 is turned on, a data signal supplied through the first data line DL1 is stored at the capacitor Cst in a data voltage form.

In the second transistor T2, a gate electrode is connected to a Bth scan line SNB, a first electrode is connected to one end of the capacitor Cst, and a second electrode is connected to the other end of the capacitor Cst. The second transistor T2 operates to correspond to the Bth scan signal supplied through the Bth scan line SNB. When the second transistor T2 is turned on, a data voltage stored at the capacitor Cst is erased.

In the capacitor Cst, one end thereof is connected to a second electrode of the first transistor T1 and a first electrode of the second transistor T2 and the other end thereof is connected to a gate electrode of the driving transistor DT and a second electrode of the second transistor T2. The capacitor Cst provides a stored data voltage to a gate electrode of the driving transistor DT.

In the driving transistor DT, a gate electrode is connected to the capacitor Cst, a first electrode is connected to a first power source line EVDD, and a second electrode is connected to an anode electrode of the OLED. The driving transistor DT operates to correspond to a data voltage stored at the capacitor Cst.

In the OLED, an anode electrode is connected to a second electrode of the driving transistor DT and a cathode electrode is connected to a second power source line EVSS. The OLED emits light to correspond to a time in which the driving transistor DT is turned on.

In the foregoing description, the first electrode and the second electrode may be defined to a source electrode and a drain electrode or a drain electrode and a source electrode of a transistor according to a characteristic or a direction of the transistor.

A subpixel according to a first exemplary embodiment not covered by the present invention operates to correspond to a scan signal supplied through two scan lines of an Ath scan line SNA and a Bth scan line SNB. The Ath scan line SNA and the Bth scan line SNB are included in a first scan line GL1. The first transistor T1 and the second transistor T2 included in a subpixel according to a first exemplary embodiment not covered by the present invention are formed in a P type and a driving waveform thereof is shown in FIG. 7.

An Ath scan signal Scan is supplied to the Ath scan line SNA. The Ath scan signal Scan (logic low; L portion) supplied through the Ath scan line SNA defines Addressing that transfers a data signal to the subpixel. When the Ath scan signal Scan corresponding to logic low L is supplied through the Ath scan line SNA, the subpixel stores a data signal Vdata as a data voltage to correspond to Addressing.

A (B-1)th scan signal Reset and a (B-2)th scan signal Erase are supplied to the Bth scan line SNB. The (B-1)th scan signal Reset (logic low; L portion) supplied through the Bth scan line SNB defines an initialization time that initializes a subpixel. When the (B-1)th scan signal Reset corresponding to logic low L is supplied through the Bth scan line SNB, the subpixel initializes nodes of both ends of the capacitor Cst to correspond to an initialization time.

An initialization time using the (B-1)th scan signal Reset may occur before a data signal Vdata is supplied. A time point in which the (B-1)th scan signal Reset occurs may be synchronized with a time point in which the Ath scan signal Scan drops to logic low L or may be a time point a little faster than or a time point a little slower than a time point in which the Ath scan signal Scan drops to logic low L.

A (B-2)th scan signal Erase (logic low; L portion) supplied through the Bth scan line SNB defines Erase that erases a data voltage stored at a subpixel. When the (B-2)th scan signal Erase corresponding to logic low L is supplied through the Bth scan line SNB, the subpixel erases a data voltage to correspond to Erase. A time point in which the (B-2)th scan signal Erase occurs corresponds to a time point in which Emission of each subpixel is terminated.

The (B-1)th scan signal Reset and the (B-2)th scan signal Erase erase a potential of the capacitors Cst with a method of short-circuiting nodes of both ends of the capacitor Cst by turning on the second transistor T2, but are functionally different, as described above and thus the (B-1)th scan signal Reset and the (B-2)th scan signal Erase are distinguished.

A data voltage transferred through a data line is supplied as a voltage that can emit a subpixel to correspond to Addressing, but may be changed to a voltage that cannot emit (turn off) a subpixel to correspond to an initialization time or Erase.

As can be seen through FIGS. 6 and 7, in a first exemplary embodiment not covered by the present invention, driving of the second transistor T2 using a (B-1)th scan signal Reset and a (B-2)th scan signal Erase supplied through the Bth scan line SNB, initialization driving of a subpixel based on the second transistor T2, and erasing driving thereof has been described as an example.

An initialization time is a time inserted to prevent in advance a change problem (problem by a parasitic component) of a node due to a long term that returns to Addressing after Erase and this may be omitted. Therefore, a subpixel may be erasing driven using only a (B-2)th scan signal Erase supplied through the Bth scan line SNB. That is, an initialization time may be omitted and only Erase may be used. Further, a driving waveform of FIG. 7 is an illustration and a driving waveform may be formed in different forms according to an object and an effect.

### <Second exemplary embodiment not covered by the invention>

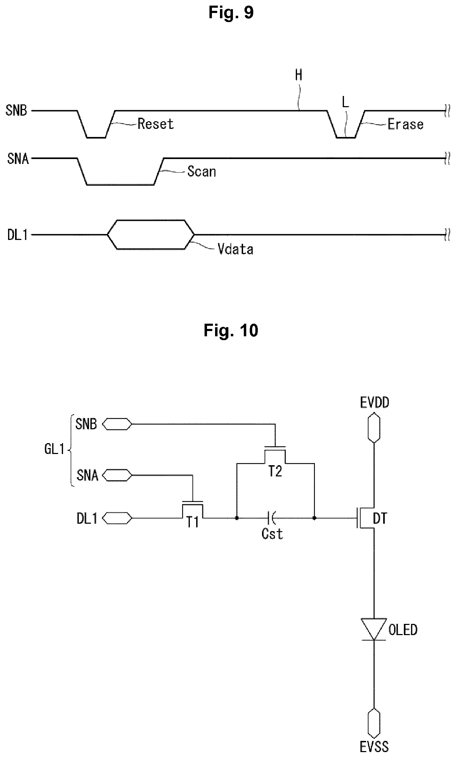

FIG. 8 is a diagram illustrating a circuit configuration of a subpixel according to a second exemplary embodiment not covered by the present invention, and FIG. 9 is a diagram illustrating a driving waveform of the subpixel of FIG. 8.

As shown in FIG. 8, a subpixel according to the second exemplary embodiment not covered by the present invention includes a first transistor T1, a second transistor T2, a capacitor Cst, a driving transistor DT, and an OLED.

In the first transistor T1, a gate electrode is connected to an Ath scan line SNA, a first electrode is connected to a first data line DL1, and a second electrode is connected to one end of the capacitor Cst. The first transistor T1 operates to correspond to an Ath scan signal supplied through the Ath scan line SNA. When the first transistor T1 is turned on, a data signal supplied through the first data line DL1 is stored at the capacitor Cst in a data voltage form.

In the second transistor T2, a gate electrode is connected to a Bth scan line SNB, a first electrode is connected to the other end of the capacitor Cst and a gate electrode of the driving transistor DT, and a second electrode is connected to a second electrode of the driving transistor DT. The second transistor T2 operates to correspond to a Bth scan signal supplied through the Bth scan line SNB. When the second transistor T2 is turned on, a node of a gate electrode of the driving transistor DT and a node of a second electrode are short-circuited, the driving transistor DT is turned off by a high voltage (e.g., because a voltage higher than Vgs = 0 is applied) flowing through the second electrode. In addition, a data voltage stored at the capacitor Cst is erased by a high voltage flowing through the second electrode.

In the capacitor Cst, one end thereof is connected to a second electrode of the first transistor T1 and a first electrode of the second transistor T2 and the other end thereof is connected to a gate electrode of the driving transistor DT and a second electrode of the second transistor T2. The capacitor Cst provides a stored data voltage to a gate electrode of the driving transistor DT.

In the driving transistor DT, a gate electrode is connected to the capacitor Cst, a first electrode is connected to a first power source line EVDD, and a second electrode is connected to an anode electrode of the OLED. The driving transistor DT operates to correspond to a data voltage stored at the capacitor Cst.

In the OLED, an anode electrode is connected to a second electrode of the driving transistor DT and a cathode electrode is connected to a second power source line EVSS. The OLED emits light to correspond to a time in which the driving transistor DT is turned on.

In the foregoing description, the first electrode and the second electrode may be defined to a source electrode and a drain electrode or a drain electrode and a source electrode of a transistor according to a characteristic or a direction of the transistor.

A subpixel according to the second exemplary embodiment not covered by the present invention operates to correspond to a scan signal supplied through two scan lines of an Ath scan line SNA and a Bth scan line SNB. The Ath scan line SNA and the Bth scan line SNB are included in a first scan line GL1. The first transistor T1 and the second transistor T2 included in a subpixel according to a third exemplary embodiment of the present invention are formed in a P type and a driving waveform thereof is shown in FIG. 9.

An Ath scan signal Scan is supplied to the Ath scan line SNA. The Ath scan signal Scan (logic low; L portion) supplied through the Ath scan line SNA defines Addressing that transfers a data signal to the subpixel. When the Ath scan signal Scan corresponding to logic low L is supplied through the Ath scan line SNA, the subpixel stores a data signal Vdata as a data voltage to correspond to Addressing.

A (B-1)th scan signal Reset and a (B-2)th scan signal Erase are supplied to the Bth scan line SNB. The (B-1)th scan signal Reset (logic low; L portion) supplied through the Bth scan line SNB defines an initialization time that initializes a subpixel. When the (B-1)th scan signal Reset corresponding to logic low L is supplied through the Bth scan line SNB, the subpixel short-circuits and initializes a node of the gate electrode of the driving transistor DT and a node of the second electrode to correspond to an initialization time.

An initialization time using the (B-1)th scan signal Reset may occur before a data signal Vdata is supplied. A time point in which the (B-1)th scan signal Reset occurs may be synchronized with a time point in which the Ath scan signal Scan drops to logic low L or may be a time point a little faster than or a time point a little slower than a time point in which the Ath scan signal Scan drops to logic low L.

A (B-2)th scan signal Erase (logic low; L portion) supplied through the Bth scan line SNB defines Erase that erases a data voltage stored at a subpixel. When the (B-2)th scan signal Erase corresponding to logic low L is supplied through the Bth scan line SNB, the subpixel erases a data voltage to correspond to Erase. A time point in which the (B-2)th scan signal Erase occurs corresponds to a time point in which Emission of each subpixel is terminated.

The (B-1)th scan signal Reset and the (B-2)th scan signal Erase erase a potential of the capacitors Cst with a method of short-circuiting a node of the gate electrode of the driving transistor DT and a node of the second electrode by turning on the second transistor T2, but are functionally different, as described above and thus the (B-1)th scan signal Reset and the (B-2)th scan signal Erase are distinguished.

A data voltage transferred through a data line is supplied as a voltage that can emit a subpixel to correspond to Addressing, but may be changed to a voltage that cannot emit (turn off) a subpixel to correspond to an initialization time or Erase.

As can be seen through FIGS. 8 and 9, in the second exemplary embodiment not covered by embodiment the present invention, driving of the second transistor T2 using a (B-1)th scan signal Reset and (B-2)th scan signal Erase supplied through the Bth scan line SNB, initialization driving of a subpixel based on the second transistor T2, and erasing driving thereof has been described as an example.

An initialization time is a time inserted to prevent in advance a change problem (problem by a parasitic component) of a node due to a long term that returns to Addressing after Erase and this may be omitted. Therefore, a subpixel may be erasing driven using only a (B-2)th scan signal Erase supplied through the Bth scan line SNB. That is, an initialization time may be omitted and only Erase may be used. Further, a driving waveform of FIG. 9 is an illustration and a driving waveform may be formed in different forms according to an object and an effect.

### <Third exemplary embodiment not covered by the invention>

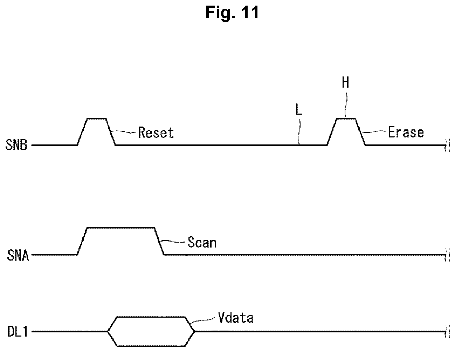

FIG. 10 is a diagram illustrating a circuit configuration of a subpixel according to a third exemplary embodiment not covered by the present invention and FIG. 11 is a diagram illustrating a driving waveform of the subpixel of FIG. 10.

As shown in FIG. 10, a subpixel according to a third exemplary embodiment not covered by the present invention includes a first transistor T1, a second transistor T2, a capacitor Cst, a driving transistor DT, and an OLED.

In the first transistor T1, a gate electrode is connected to an Ath scan line SNA, a first electrode is connected to a first data line DL1, and a second electrode is connected to one end of the capacitor Cst. The first transistor T1 operates to correspond to an Ath scan signal supplied through the Ath scan line SNA. When the first transistor T1 is turned on, a data signal supplied through the first data line DL1 is stored at the capacitor Cst in a data voltage form.

In the second transistor T2, a gate electrode is connected to a Bth scan line SNB, a first electrode is connected to one end of the capacitor Cst, and a second electrode is connected to the other end of the capacitor Cst. The second transistor T2 operates to correspond to a Bth scan signal supplied through the Bth scan line SNB. When the second transistor T2 is turned on, a data voltage stored at the capacitor Cst is erased.

In the capacitor Cst, one end thereof is connected to a second electrode of the first transistor T1 and a first electrode of the second transistor T2 and the other end thereof is connected to a gate electrode of the driving transistor DT and a second electrode of the second transistor T2. The capacitor Cst provides a stored data voltage to a gate electrode of the driving transistor DT.

In the driving transistor DT, a gate electrode is connected to the capacitor Cst, a first electrode is connected to a first power source line EVDD, and a second electrode is connected to an anode electrode of the OLED. The driving transistor DT operates to correspond to a data voltage stored at the capacitor Cst.

In the OLED, an anode electrode is connected to a second electrode of the driving transistor DT and a cathode electrode is connected to a second power source line EVSS. The OLED emits light to correspond to a time in which the driving transistor DT is turned on.

In the foregoing description, a first electrode and a second electrode may be defined to a source electrode and a drain electrode or a drain electrode and a source electrode of a transistor according to a characteristic or a direction of the transistor.

A subpixel according to the third exemplary embodiment not covered by the present invention operates to correspond to a scan signal supplied through two scan lines of an Ath scan line SNA and a Bth scan line SNB. The Ath scan line SNA and the Bth scan line SNB are included in a first scan line GL1. The first transistor T1 and the second transistor T2 included in a subpixel according to a third exemplary embodiment not covered by embodiment the present invention are formed in an N type and a driving waveform thereof is shown in FIG. 11.

An Ath scan signal Scan is supplied to the Ath scan line SNA. The Ath scan signal Scan (logic high; H portion) supplied through the Ath scan line SNA defines Addressing that transfers a data signal to the subpixel. When the Ath scan signal Scan corresponding to logic high H is supplied through the Ath scan line SNA, the subpixel stores a data signal Vdata as a data voltage to correspond to Addressing.

A (B-1)th scan signal Reset and a (B-2)th scan signal Erase are supplied to the Bth scan line SNB. The (B-1)th scan signal Reset (logic high; H portion) supplied through the Bth scan line SNB defines an initialization time that initializes a subpixel. When the (B-1)th scan signal Reset corresponding to logic high H is supplied through the Bth scan line SNB, the subpixel initializes nodes of both ends of the capacitor Cst to correspond to an initialization time.

An initialization time using the (B-1)th scan signal Reset may occur before a data signal Vdata is supplied. A time point in which the (B-1)th scan signal Reset occurs may be synchronized with a time point in which the Ath scan signal Scan rises to logic high H or may be a time point a little faster than or a time point a little slower than a time point in which the Ath scan signal Scan rises to logic high H.

A (B-2)th scan signal Erase (logic high; H portion) supplied through the Bth scan line SNB defines Erase that erases a data voltage stored at a subpixel. When the (B-2)th scan signal corresponding to logic high H is supplied through the Bth scan line SNB, the subpixel erases a data voltage to correspond to Erase. A time point in which the (B-2)th scan signal Erase occurs corresponds to a time point in which Emission of each subpixel is terminated.

The (B-1)th scan signal Reset and the (B-2)th scan signal Erase erase a potential of the capacitors Cst with a method of short-circuiting nodes of both ends of the capacitor Cst by turning on the second transistor T2, but are functionally different, as described above and thus the (B-1)th scan signal Reset and the (B-2)th scan signal Reset are distinguished.

A data voltage transferred through a data line is supplied as a voltage that can emit a subpixel to correspond to Addressing, but may be changed to a voltage that cannot emit (turn off) a subpixel to correspond to an initialization time or Erase.

As can be seen through FIGS. 10 and 11, in the third exemplary embodiment not covered by embodiment the present invention, driving of the second transistor T2 using a (B-1)th scan signal Reset and (B-2)th scan signal Erase supplied through the Bth scan line SNB, initialization driving of a subpixel based on the second transistor T2, and erasing driving thereof has been described as an example.

An initialization time is a time inserted to prevent in advance a change problem (problem by a parasitic component) of a node due to a long term that returns to Addressing after Erase and this may be thus omitted. Therefore, a subpixel may be erasing driven using only a (B-2)th scan signal Erase supplied through the Bth scan line SNB. That is, an initialization time may be omitted and only Erase may be used. Further, a driving waveform of FIG. 11 is an illustration, and a driving waveform may be formed in different forms according to an object and an effect.

The embodiments use a subpixel that can easily apply Erase that can enhance driving accuracy by removing (or preventing) an error occurrence factor upon digital driving. Therefore, the present invention can be applied to an Address Display Separation (ADS) driving method in which Addressing and Emission are separated as well as an AWD driving method.

The embodiments illustrate subframes sequentially disposed from a lowermost bit LSB to an uppermost bit MSB as an example. However, this is an illustration, and in order to form the optical center in various forms, a subframe may be randomly disposed from a lowermost bit LSB to an uppermost bit MSB. Further, the embodiments illustrate five subframes formed within one frame as an example. However, this is an illustration, and the number of subframes may be formed with various numbers of four, six, and eight.

As described above, the present invention can enhance a problem that an image quality deviation occurs due to an error occurrence factor in which a voltage that determines actual luminance of a subpixel for a subframe changes. Further, the present invention can enhance driving accuracy and improve a display quality by removing (or preventing) an error occurrence factor with elements of the small number.

## Claims

1. An Organic Light Emitting Display "OLED", comprising:
a display panel (150) having subpixels;
a scan driver (140) operable to supply a scan signal to the display panel (150); and
a data driver (130) operable to supply a data signal comprising a plurality of subframes,
wherein each subframe includes an initialization time between a first node and a during which a voltage second node of the plurality of subpixels are initialized,
an addressing time during which a data signal is transferred to the subpixel, an emission time during which the subpixel emits light, and an erase time during which a data voltage stored at the subpixel is erased, wherein the initialization time precedes the emission time and erase time in each subframe,
wherein the erasing during the erase time comprises erasing a data voltage stored at a capacitor (Cst) of the subpixel,
wherein each of the plurality of subpixels comprises:
a first transistor (Tl) having a gate electrode connected to an Ath scan line (SNA), a first electrode connected to a first data line (DL1), and a second electrode connected to one end of the capacitor;
a second transistor (T2) having a gate electrode connected to a Bth scan line (SNB), a first electrode connected to the first data line, and a second electrode connected to the other end of the capacitor;
wherein the capacitor has one end connected to the second electrode of the first transistor and the other end connected to a gate electrode of a driving transistor (DT) and a second electrode of the second transistor,
wherein the driving transistor has a gate electrode connected to the other end of the capacitor (Cst), a first electrode connected to a first power source line (EVDD), and a second electrode connected to an anode electrode of an organic light emitting diode (OLED),
wherein the organic light emitting diode (OLED) has an anode electrode connected to a second electrode of the driving transistor and a cathode electrode connected to a second power source line (EVSS),
wherein the first node is formed by the connection of the first electrode of the the first transistor, the first electrode of the second transistor and the first data line, and the second node is formed by the connection of the second electrode of the second transistor, the gate of the driving transistor and the other end of the capacitor (Cst),
wherein the erasing during the erase time and the initialization time comprises short-circuiting the first node and the second node of the subpixel, and
wherein the data driver is configured to supply a data voltage through the first data line, during the initialization time and erase time, that turns off the subpixel.

2. A method of driving the Organic Light Emitting Display (OLED) of claim 1, the method comprising for each subframe:
an initialization time during which a voltage at the subpixel is erased; and
an addressing time comprising transferring a data signal to the subpixel and storing the data signal as a data voltage while supplying an Ath scan signal to the Ath scan line connected to the subpixel; and
an emission time comprising emitting light in correspondence to the data voltage; and
an erase time comprising supplying a Bth scan signal to the Bth scan line connected to the subpixel and erasing a data voltage stored at the subpixel,
wherein the initialization time precedes the emission time and erase time in each subframe,
wherein the erasing during the erase time and the initialization time comprises short-circuiting the first node and the second node,
wherein the erasing during the erase time comprises erasing a data voltage stored at the capacitor of the subpixel, and
wherein the data driver supplies a data voltage through the first data line, during the initialization time and erase time, that turns off the subpixel.

## Patentansprüche

1. Organische lichtemittierende Anzeige, "OLED"-Anzeige, die Folgendes umfasst:
eine Anzeigetafel (150), die Unterpixel besitzt;
eine Abtastansteuerung (140), die betreibbar ist, um an die Anzeigetafel (150) ein Abtastsignal zu liefern; und
eine Datenansteuerung (130), die betreibbar ist, ein Datensignal, das mehrere Unterrahmen enthält, zu liefern,
wobei jeder Unterrahmen eine Initialisierungszeit, in der eine Spannung zwischen einem ersten Knoten und einem zweiten Knoten der mehreren Unterpixel initialisiert wird, eine Adressierungszeit, in der ein Datensignal an das Unterpixel übertragen wird, eine Emissionszeit, in der das Unterpixel Licht emittiert, und eine Löschzeit, in der eine Datenspannung, die bei dem Unterpixel gespeichert ist, gelöscht wird, enthält, wobei die Initialisierungszeit der Emissionszeit und der Löschzeit in jedem Unterrahmen vorhergeht,
wobei das Löschen in der Löschzeit das Löschen einer Datenspannung, die bei einem Kondensator (Cst) des Unterpixels gespeichert ist, umfasst,
wobei jedes der mehreren Unterpixel Folgendes enthält:
einen ersten Transistor (Tl), wovon eine Gate-Elektrode mit einer A-ten Abtastzeile (SNA) verbunden ist, eine erste Elektrode mit einer ersten Datenleitung (DL1) verbunden ist und eine zweite Elektrode mit einem Ende des Kondensators verbunden ist;
einen zweiten Transistor (T2), wovon eine Gate-Elektrode mit einer B-ten Abtastzeile (SNB) verbunden ist, eine erste Elektrode mit der ersten Datenleitung verbunden ist und eine zweite Elektrode mit dem anderen Ende des Kondensators verbunden ist;
wobei ein Ende des Kondensators mit der zweiten Elektrode des ersten Transistors verbunden ist und sein anderes Ende mit einer Gate-Elektrode eines Ansteuertransistors (DT) und mit einer zweiten Elektrode des zweiten Transistors verbunden ist,
wobei die Gate-Elektrode des Ansteuertransistors mit dem anderen Ende des Kondensators (Cst) verbunden ist, seine erste Elektrode mit einer ersten Leistungsquellenleitung (EVDD) verbunden ist und seine zweite Elektrode mit einer Anoden-Elektrode einer organischen Leuchtdiode (OLED) verbunden ist,
wobei eine Anoden-Elektrode der organischen Leuchtdiode (OLED) mit einer zweiten Elektrode des Ansteuertransistors verbunden ist und ihre Katoden-Elektrode mit einer zweiten Leistungsversorgungsleitungen (EVSS) verbunden ist,
wobei der erste Knoten durch die Verbindung der ersten Elektrode des ersten Transistors, die erste Elektrode des zweiten Transistors und die erste Datenleitung gebildet ist und der zweite Knoten durch die Verbindung der zweiten Elektrode des zweiten Transistors, das Gate des Ansteuertransistors und das andere Ende des Kondensators (Cst) gebildet ist,
wobei das Löschen in der Löschzeit und der Initialisierungszeit das Kurzschließen des ersten Knotens und des zweiten Knotens des Unterpixels umfasst und
wobei die Datenansteuerung konfiguriert ist, in der Initialisierungszeit und in der Löschzeit über die erste Datenleitung eine Datenspannung zu liefern, die das Unterpixel ausschaltet.

2. Verfahren zum Ansteuern der organischen lichtemittierenden Anzeige (OLED-Anzeige) nach Anspruch 1, wobei das Verfahren für jeden Unterrahmen Folgendes umfasst:
eine Initialisierungszeit, in der eine Spannung bei dem Unterpixel gelöscht wird; und
eine Adressierungszeit, die das Übertragen eines Datensignals an das Unterpixel und das Speichern des Datensignals als eine Datenspannung während der Lieferung des A-ten Abtastsignals an die A-te Abtastzeile, die mit dem Unterpixel verbunden ist, umfasst; und
eine Emissionszeit, die das Aussenden von Licht in Übereinstimmung mit der Datenspannung umfasst; und
eine Löschzeit, die das Liefern eines B-ten Abtastsignals an die B-te Abtastzeile, die mit dem Unterpixel verbunden ist, und das Löschen einer bei dem Unterpixel gespeicherten Datenspannung umfasst,
wobei die Initialisierungszeit der Emissionszeit und der Löschzeit in jedem Unterrahmen vorhergeht,
wobei das Löschen in der Löschzeit und in der Initialisierungszeit das Kurzschließen des ersten Knotens und des zweiten Knotens umfasst,
wobei das Löschen in der Löschzeit das Löschen einer in einem Kondensator des Unterpixels gespeicherten Datenspannung umfasst und
wobei die Datenansteuerung in der Initialisierungszeit und in der Löschzeit über die erste Datenleitung eine Datenspannung liefert, die das Unterpixel ausschaltet.

## Revendications

1. Affichage organique électroluminescent « OLED », comprenant :
un panneau d'affichage (150) comportant des sous-pixels ;
un pilote de balayage (140) pouvant fonctionner pour fournir un signal de balayage au panneau d'affichage (150) ; et
un pilote de données (130) utilisable pour fournir un signal de données comprenant une pluralité de soustrames,
chaque sous-trame comprenant un temps d'initialisation pendant lequel une tension entre un premier nœud et un second noeud de la pluralité de sous-pixels est initialisée, un temps d'adressage pendant lequel un signal de données est transféré au sous-pixel, un temps d'émission pendant lequel le sous-pixel émet de la lumière, et un temps d'effacement pendant lequel une tension de données stockée au niveau du sous-pixel est effacée, le temps d'initialisation précédant le temps d'émission et le temps d'effacement dans chaque sous-trame,
l'effacement pendant le temps d'effacement comprenant l'effacement d'une tension de données stockée au niveau d'un condensateur (Cst) du sous-pixel,
chacun de la pluralité de sous-pixels comprenant :
un premier transistor (Tl) ayant une électrode de grille connectée à une A-ième ligne de balayage (SNA), une première électrode connectée à une première ligne de données (DL1), et une seconde électrode connectée à une extrémité du condensateur ;
un second transistor (T2) ayant une électrode de grille connectée à une B-ième ligne de balayage (SNB), une première électrode connectée à la première ligne de données, et une seconde électrode connectée à l'autre extrémité du condensateur ;
le condensateur ayant une extrémité connectée à la seconde électrode du premier transistor et l'autre extrémité connectée à une électrode de grille d'un transistor de commande (DT) et à une seconde électrode du second transistor,
le transistor de commande ayant une électrode de grille connectée à l'autre extrémité du condensateur (Cst),
une première électrode connectée à une première ligne de source d'alimentation (EVDD), et une seconde électrode connectée à une électrode d'anode d'une diode électroluminescente organique (OLED),
la diode électroluminescente organique (OLED) ayant une électrode d'anode connectée à une seconde électrode du transistor de commande et une électrode de cathode connectée à une seconde ligne de source d'alimentation (EVSS),
le premier noeud étant formé par la connexion de la première électrode du premier transistor, de la première électrode du second transistor et de la première ligne de données, et le second noeud étant formé par la connexion de la seconde électrode du second transistor, de la grille du transistor de commande et de l'autre extrémité du condensateur (Cst),
l'effacement pendant le temps d'effacement et le temps d'initialisation comprenant la mise en courtcircuit du premier noeud et du second noeud du sous-pixel, et
le pilote de données étant configuré pour fournir une tension de données à travers la première ligne de données, pendant le temps d'initialisation et le temps d'effacement, qui éteint le sous-pixel.

2. Procédé de commande de l'affichage organique électroluminescent (OLED) selon la revendication 1, le procédé comprenant pour chaque sous-trame :
un temps d'initialisation pendant lequel une tension au niveau du sous-pixel est effacée ; et
un temps d'adressage comprenant le transfert d'un signal de données au sous-pixel et le stockage du signal de données comme une tension de données tout en fournissant un A-ième signal de balayage à la A-ième ligne de balayage connectée au sous-pixel ; et
un temps d'émission comprenant l'émission de lumière en correspondance avec la tension de données ; et
un temps d'effacement comprenant la fourniture d'un B-ième signal de balayage à la B-ième ligne de balayage connectée au sous-pixel et l'effacement d'une tension de données stockée au niveau du sous-pixel,
le temps d'initialisation précédant le temps d'émission et le temps d'effacement dans chaque sous-trame,
l'effacement pendant le temps d'effacement et le temps d'initialisation comprenant la mise en courtcircuit du premier noeud et du second nœud,
l'effacement pendant le temps d'effacement comprenant l'effacement d'une tension de données stockée au niveau du condensateur du sous-pixel, et
le pilote de données fournissant une tension de données à travers la première ligne de données, pendant le temps d'initialisation et le temps d'effacement, qui éteint le sous-pixel.
